# EUROPÄISCHE PATENTSCHRIFT

(11) **EP 0 793 113 B1**
(45) Veröffentlichungstag und Bekanntmachung des Hinweises auf die Patenterteilung: **21.11.2001**
(21) Anmeldenummer: 97200429.5
(22) Anmeldetag: 17.02.1997
(51) Int. Cl.: G01R 33/567

(54) **MR-Verfahren mit reduzierten Bewegungsartefakten**
MR method with reduced motion artifacts
Méthode RM avec des artefacts de mouvement réduits

(30) Priorität: 24.02.1996 DE 19607023
(43) Veröffentlichungstag der Anmeldung: 03.09.1997
(73) Patentinhaber: Philips Corporate Intellectual Property GmbH, 52064 Aachen (DE); Koninklijke Philips Electronics N.V., 5621 BA Eindhoven (NL)
(72) Erfinder: Börnert, Peter, Dr., Röntgenstrasse 24, 22335 Hamburg (DE); Schäffter, Tobias, Röntgenstrasse 24, 22335 Hamburg (DE); Weiger, Markus, Röntgenstrasse 24, 22335 Hamburg (DE)
(74) Vertreter: Hartmann, Heinrich, Dipl.-Ing.

(56) Entgegenhaltungen:
- EP-A- 0 172 345
- WO-A-87/00923
- US-A- 4 663 591
- US-A- 5 042 485
- US-A- 5 363 844
- PATENT ABSTRACTS OF JAPAN vol. 013, no. 592 (C-671), 26.Dezember 1989 & JP 01 250234 A (SHIMADZU CORP), 5.Oktober 1989,
- PATENT ABSTRACTS OF JAPAN vol. 014, no. 184 (C-0709), 13.April 1990 & JP 02 031737 A (FUJI ELECTRIC CO LTD), 1.Februar 1990,
- M.L.WOOD ET AL.: "Suppression of respiratory motion artifacts in magnetic resonance imaging", MED.PHYS., , 1986, Band 13, Nr. 6, Seiten 794 - 805

## Beschreibung

Die Erfindung betrifft ein MR-Verfahren mit reduzierten Bewegungsartefakten, bei dem fortlaufend die Verschiebung eines in einem Untersuchungsbereich befindlichen pulsierenden Objektes oder eines Teils davon aus einer Referenzlage gemessen wird, und bei dem nur diejenigen im Untersuchungsbereich erzeugten MR-Signale für die Rekonstruktion eines MR-Bildes herangezogen werden, bei deren Erfassung die Verschiebung aus der Referenzlage einen Schwellenwert erreicht bzw. unterschreitet. Außerdem betrifft die Erfindung eine Anordnung zur Durchführung eines solchen Verfahrens.

Ein solches Verfahren und eine solche Anordnung sind aus einer Veröffentlichung von Sachs et al in der Zeitschrift **MRM 33**, pp 639-645 (1994) bekannt. Bei länger andauernden MR-Untersuchungen (MR = Magnetresonanz) treten Bewegungsartefakte insbesondere als Folge von Atembewegungen des zu untersuchenden Patienten auf. Teile des Patientenkörpers führen dabei eine hin- und hergehende (pulsierende) Bewegung aus, die in einem MR-Bild, das mit Hilfe der bei dieser Untersuchung gewonnenen MR-Signale rekonstruiert wird, Bewegungsartefakte hervorrufen.

Bei dem bekannten Verfahren wird die Atembewegung fortlaufend mit Hilfe sogenannter Navigatorimpulse gemessen. Es werden diejenigen im Untersuchungsbereich erzeugten MR-Signale zur Rekonstruktion eines MR-Bildes herangezogen, bei denen die atmungsbedingte Verschiebung des Untersuchungsobjekts bzw. eines Teils davon aus einer Referenzlage einen Schwellenwert nicht überschreitet. Bei dem bekannten Verfahren erfolgt die Untersuchung mit Hilfe der sogenannten Spiral-MRI, doch kann es auch bei anderen MR-Sequenzen angewandt werden.

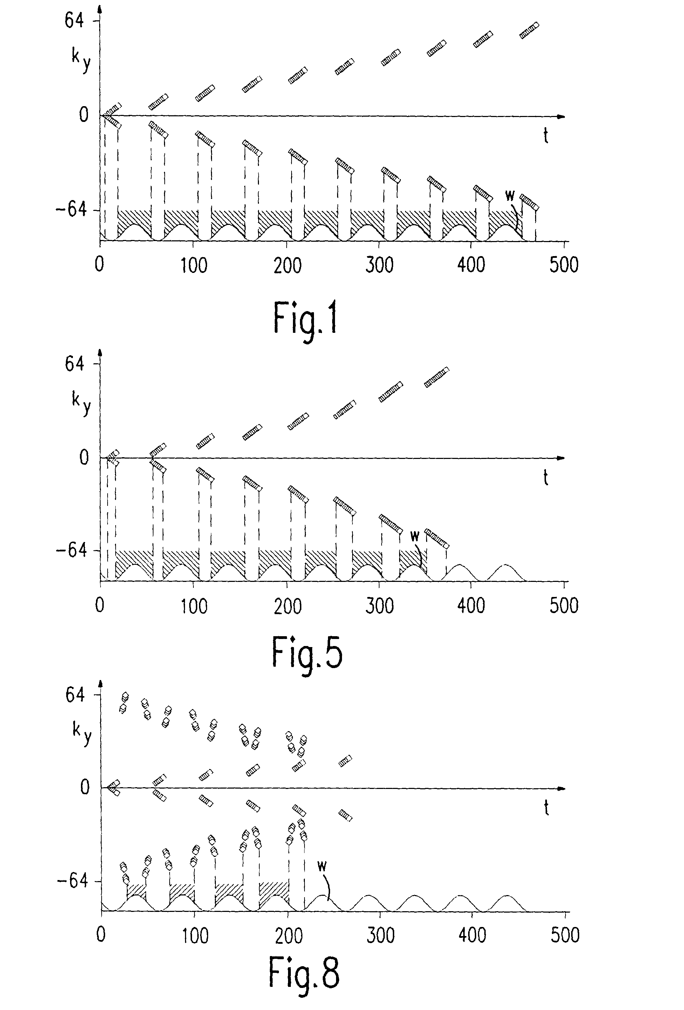

Fig. 1 zeigt, wie bei dem bekannten Verfahren MR-Signale mit unterschiedlichen Phasenkodierungen erfaßt werden. Dabei wird davon ausgegangen, daß die Phasenkodierung durch ein magnetisches Gradientenfeld mit einem in y-Richtung wirkenden Gradienten erzeugt wird und daß die MR-Signale bzw. die Kernmagnetisierung im Untersuchungsbereich bei einer bestimmten zeitlichen Folge der Phasenkodierung bzw. des zeitlichen Integrals über den Phasenkodierungsgradienten (dieses Integral wird üblicherweise mit k_{y} bezeichnet) erfaßt werden. Dementsprechend stellt die Ordinate den jeweiligen k_{y} Wert dar, während die Abszisse die Zeit darstellt bzw. die Zahl der Anregungen der Kernmagnetisierung im Untersuchungsbereich, wobei davon ausgegangen wird, daß diese Anregungen sich nach einer bestimmten Zeit (z.B. 15 ms wiederholen). Unterhalb der Koordinate ist außerdem der zeitliche Verlauf der Verschiebung des Objektes bzw. eines Teils davon als Funktion der Zeit dargestellt. Obwohl bei dem bekannten Verfahren durch fortlaufende Anregung MR-Signale erzeugt werden, werden diese nicht alle gespeichert bzw. zur Rekonstruktion eines MR-Bildes herangezogen. Erst wenn die Verschiebung v einen vorgebbaren Schwellenwert unterschreitet, werden die im Untersuchungsbereich erzeugten MR-Signale erfaßt und gespeichert, wobei die Phasenkodierung dem Betrage nach wächst. In Fig. 1 ist dies durch kleine Quadrate dargestellt; jedes Quadrat bedeutet eine bestimmte Phasenkodierung, bzw. ein mit dieser Phasenkodierung akquiriertes und gespeichertes MR-Signal.

Wenn die Verschiebung den Schwellenwert überschreitet, werden die auftretenden MR-Signale nicht mehr erfaßt, weil ihre Verarbeitung zu Bewegungsartefakten im MR-Bild führen würde. Erst nach einer weiteren Atemperiode wird wieder ein Zustand erreicht, in dem erneut eine Erfassung und Speicherung der MR-Signale-mit einer anderen Phasenkodierung - möglich ist. Dies wiederholt sich in jeder Atemperiode, bis für jeden der z.B. 128 verschiedenen k_{y} Werte ein MR-Signal erfaßt und gespeichert worden ist.

Wenn man davon ausgeht, daß der Körper des Patienten sich nur während etwa 25% einer jeden Atemperiode in einer Bewegungsphase w befindet, die nicht bzw. nur in geringem Umfang zu Bewegungsartefakten im MR-Bild führt, bedeutet dies, daß erst nach mehr als 500 Anregungen der Kernmagnetisierungsbereich die für die Rekonstruktion eines MR-Bildes mit verringerten Bewegungsartefakten erforderlichen 128 MR-Signale erfaßt und gespeichert worden sind.

Ein günstigerer Kompromiß zwischen Bildqualität und Untersuchungsdauer ergibt sich bei dem aus dem japanischen Patent JP 1-250234 bekannten Verfahren dadurch, daß MR-Signale bei einem niedrigen Phasenkodierungsgradienten nur bei einem Bewegungsstillstand erfaßt werden, während nach einem größeren Phasenkodierungsgradienten die MR-Signale auch dann erfaßt werden, wenn eine etwas größere Verschiebung registriert worden ist.

Aufgabe der Erfindung ist es demgegenüber, die Untersuchungsdauer noch weiter zu verkürzen ohne die Bildqualität zu beeinträchtigen. Diese Aufgabe wird durch die im Anspruch 1 angegebenen Maßnahmen gelöst.

Bei der Erfindung wird also keine bestimmte zeitliche Folge der Phasenkodierungsgradienten vorgesehen. Es wird vielmehr festgestellt, welcher Phasenkodierungsgradient bei dem durch die jeweils gemessene Verschiebung vorgegebenen Schwellenwert geschaltet werden darf und dieser Phasendodierungsgradient wird vorgegeben, bevor das nächste MR-Signal erfaßt wird. Dadurch lassen sich die Untersuchungszeit und/oder die Bewegungsartefakte gegenüber einem Verfahren mit einer fest vorgegebenen Folge der Phasenkodierungsgradienten deutlich reduzieren. Bei dieser Ausgestaltung kann eine Anregung der Kernmagnetisierung mit einem bestimmten Phasenkodierungsgradienten wiederholt werden, wenn - meist gegen Ende der Untersuchungszeit - dafür noch genügend Zeit vorhanden ist. Von den MR-Signalen, die mit derselben Phasenkodierung erfaßt wurden, kann dann dasjenige ausgewählt werden, bei dessen Erfassung die Verschiebung der Referenzlage am geringsten war. Dies setzt allerdings voraus, daß man zusätzlich zu dem MR-Signal die Verschiebung gegenüber der Referenzlage speichert, bei der das betreffende MR-Signal erfaßt wurde.

In weiterer Ausgestaltung der Erfindung ist vorgesehen, daß der Schwellenwert mit zunehmendem Integral des Phasenkodierungsgradienten vorzugsweise nach einer kubischen Funktion steigt. Es hat sich gezeigt, daß sich bei einem derartigen Verlauf des Schwellenwertes als Funktion der Phasenkodierung bzw. des Integrals des Phasenkodierungsgradienten ein besonders günstiger Kompromiß ergibt.

In weiterer Ausgestaltung der Erfindung ist vorgesehen, daß die Bewegung des Objektes mittels einer MR-Sequenz gemessen wird, die die Kernmagnetisierung längs einer Linie anregt. Die Bewegungsmessung kann dabei mit Hilfe von Navigatorimpulsen (ohne Phasenkodierung) erfolgen - wie an sich aus der Veröffentlichung von Sachs et al bekannt.

Es ist wichtig, die Referenzlage, von der bei der Messung der Verschiebung ausgegangen wird, so zu bestimmen, daß das Objekt sich möglichst lange in dieser Lage bzw. einem kleinen Bereich um diese Referenzlage herum befindet. Dies kann in weiterer Ausgestaltung der Erfindung dadurch erfolgen, daß in einer Präparationsphase nur die pulsierende Bewegung des Objektes bzw, eines Teils davon gemessen wird und daß automatisch diejenige Lage als Referenzlage bestimmt wird, in der sich das Objekt mit der größten Wahrscheinlichkeit befindet.

Eine MR-Anordnung zur Durchführung des erfindungsgemäßen Verfahrens ist in Anspruch 5 angegeben.

Die Erfindung wird nachstehend anhand der Zeichnung näher erläutert. Es zeigen:
- Fig. 1: den zeitlichen Ablauf des bekannten Verfahrens,
- Fig. 2: ein Blockschaltbild eines MR-Gerätes, mit dem die Erfindung ausführbar ist,
- Fig. 3: den zeitlichen Verlauf verschiedener Signale bei einer für die Erfindung geeigneten Sequenz,
- Fig. 4: die Abhängigkeit des Schwellenwertes von der Phasenkodierung,
- Fig. 5: den zeitlichen Verlauf eines weiteren im Prinzip, z.B. aus der JP 1-250234, bekannten Verfahrens.
- Fig. 6: ein Flußdiagramm zur Erläuterung einer bevorzugten Ausführungsform der Erfindung,
- Fig. 7: eine typische Häufigkeitsverteilung der einzelnen Bewegungsphasen bei einem atmenden Patienten,
- Fig. 8: den zeitlichen Ablauf bei der bevorzugten Ausführungsform.

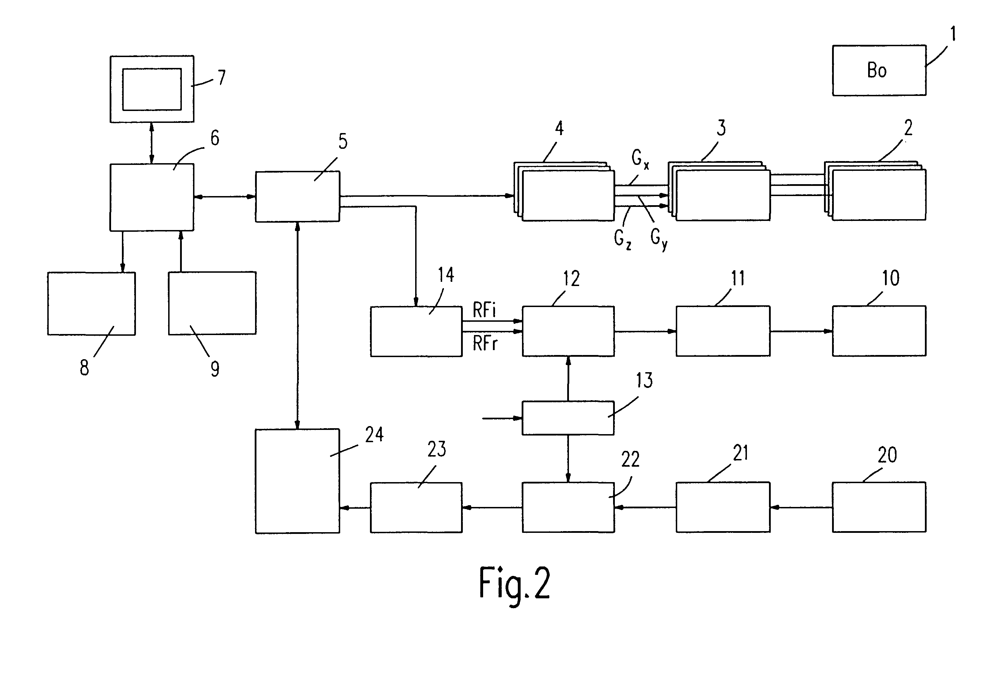

In Fig. 2 ist mit 1 ein schematisch dargestellter Hauptfeldmagnet bezeichnet, der in einem nicht näher dargestellten Untersuchungsbereich ein in z-Richtung verlaufendes stationäres und im wesentlichen homogenes Magnetfeld mit einer Stärke von z.B. 1,5 Tesla erzeugt. Weiterhin ist eine Gradientenspulenanordnung 2 vorgesehen, die in dem Untersuchungsbereich in z-Richtung verlaufende magnetische Gradientenfelder Gₓ, G_{y} und G_{z} mit einem Gradienten in x- y- oder z-Richtung erzeugen kann. Der zeitliche Verlauf der magnetischen Gradientenfelder wird von einer Generatoranordnung 4 vorgegeben, die von der Steuereinheit 5 gesteuert wird. Die Steuereinheit 5 wirkt mit einer Workstation 6 zusammen. Die Workstation ist mit einem Monitor 7 zur Wiedergabe von MR-Bildern versehen, Eingaben sind über eine Tastatur 8 oder eine interaktive Eingabeeinheit 9, z.B. einem Lichtgriffel, möglich.

Die Kernmagnetisierung im Untersuchungsbereich kann durch Hochfrequenzimpulse einer Hochfrequenzspule 10 angeregt werden, die an einen Hochfrequenzverstärker 11 angeschlossen ist, der die Ausgangssignale eines Hochfrequenzsenders 12 verstärkt. Im Hochfrequenzsender werden die Einhüllenden eines Hochfrequenzimpulses mit den von einem Oszillator 13 gelieferten Trägerschwingungen moduliert, dessen Frequenz der Larmorfrequenz (bei einem Hauptfeld von 1,5 Tesla ca. 63 MHz) entspricht. Die Einhüllende wird von der Steuereinheit 5 in einen Generator 14 geladen, der mit einem Sender 12 gekoppelt ist.

Die im Untersuchungsbereich erzeugten MR-Signale werden von einer Empfangsspule 20 aufgenommen und von einem Verstärker 21 verstärkt. Das verstärkte MR-Signal wird einem Quadraturdemodulator 22 durch zwei um 90° gegeneinander versetzte Trägerschwingungen des Oszillators demoduliert, so daß in jedem Frequenzbereich zwei Signale erzeugt werden, die als Realteil und als Imaginärteil eines komplexen MR-Signals aufgefaßt werden können. Diese Signale werden einem Analog-Digital-Wandler 23 zugeführt, der daraus MR-Daten bildet-falls die Steuereinheit 5 ihn nicht blockiert. Die MR-Daten werden in einer Rekonstruktionseinheit 24 gespeichert, die im Zusammenwirken mit der Workstation 6 aus den von einer Vielzahl von MR-Signalen abgeleiteten MR-Daten MR-Bilder rekonstruiert, die die Kernmagnetisierung im Untersuchungsbereich darstellen.

Wie weiter unten noch erläutert wird, kann die Steuereinheit 5 die Generatoranordnung 4 in Abhängigkeit von der gemessenen Bewegung bzw. Verschiebung eines im Untersuchungsbereich befindlichen Patienten steuern. Wenn die Bewegung mit einem gesonderten Sensor erfaßt wird, ist dieser an die Steuereinheit anzuschließen; wenn die Bewegung durch eine MR-Messung erfaßt wird, wird die Steuereinheit durch die Einheit 24 gesteuert, die die bei dieser MR-Messung erzeugten MR-Signale auswertet.

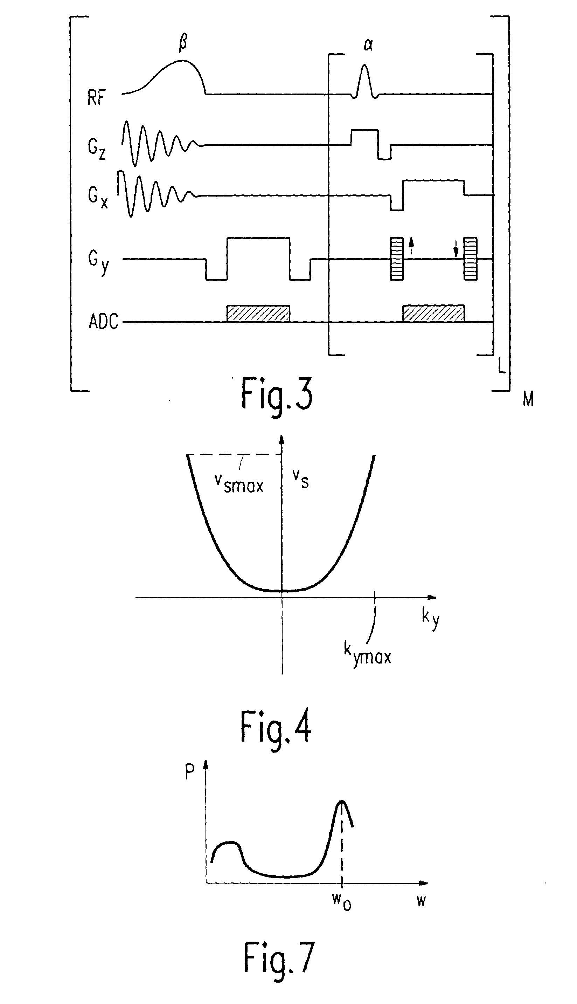

Fig. 3 zeigt eine MR-Sequenz, mit der einerseits die Verschiebung, d.h. die Bewegung des Patienten gemessen und andererseits MR-Daten aus einem bestimmten Bereich des Patienten erfaßt werden können. Die Sequenz umfaßt zunächst einen zweidimensionalen Hochfrequenzimpuls β (1. Zeile) der in zeitlichem Zusammenwirken mit zwei oszillierenden magnetischen Gradientenfeldern (in diesem Fall G_{z} und Gₓ - 2. und 3. Zeile) die Kernmagnetisierung entlang einer Linie anregt. Diese Linie ist so gewählt, daß sie einerseits möglichst außerhalb des Bereichs des Patienten verläuft, der bei der eigentlichen MR-Untersuchung abgebildet wird und andererseits z. B. das Zwerchfell des Patienten möglichst senkrecht schneidet. Dadurch entsteht in dem angeregten linienförmigen Bereich ein MR-Signal, das in Verbindung mit einem Lesegradienten - in diesem Falle G_{y} (4. Zeile) ausgelesen wird (5. Zeile). Aus diesem MR-Signal wird die Kernmagnetisierung entlang der angeregten Linie rekonstruiert. Da sich die Kernmagnetisierung relativ stark ändert, wenn die Linie das Zwerchfell schneidet, kann daraus die Bewegung w des Zwerchfells abgeleitet werden.

Anstatt mit einem zweidimensionalen Hochfrequenzimpuls kann die Bewegung auch dadurch gemessen werden, daß eine zur Hauptbewegungsrichtung des Zwerchfells senkrecht Schicht angeregt wird und aus dem daraus erzeugten MR-Signal der jeweilige Bewegungszustand abgeleitet wird. Eine solche Anregung einer ebenen Schicht ist zwar einfacher als die Anregung einer ggf. gekrümmten Linie mit einem zweidimensionalen Hochfrequenzimpuls, doch läßt sich dabei nicht immer vermeiden, daß diese Schicht auch den bei der MR-Untersuchung abzubildenden Bereich durchsetzt und dabei Artefakte hervorruft. Weiterhin ist es möglich, auf der Körperoberfläche des Patienten sogenannte Mikrospulen anzubringen und die darin induzierten MR-Signale zur Messung der jeweiligen Bewegungsphase heranzuziehen.

Darüberhinaus kann der Bewegungszustand des Patienten auch mit Hilfe anderer Sensoren erfaßt werden, die von der Magnetresonanz unabhängig sind. Beispielsweise kann ein Atemgürtel benutzt werden, der um die Brust des Patienten gelegt wird, wobei aus der relativen Längenänderung des Gürtels die Informationen über die Bewegung abgeleitet wird. Der Vorteil dieser Sensoren besteht darin, daß die Messung der Bewegung vollständig von der eigentlichen MR-Untersuchung entkoppelt werden kann. In diesem Fall würde der bisher beschriebene Teil der in Fig. 3 dargestellten Sequenz entfallen.

Nach der Messung des Bewegungszustandes wird ein schichtselektiver Hochfrequenzimpuls α erzeugt, der die Kernmagnetisierung in einer zur z-Richtung senkrechten Schicht um einen Winkel α kippt. Der Winkel α ist so gewählt, daß sich im stationären Zustand (steady state) bei der vorgegebenen Dauer dieser Sequenz (z.B. 15 ms) ein optimales MR-Signal einstellt. Vor der Erfassung des MR-Signals wird ein magnetisches Gradientenfeld - in diesem Fall G_{y} - während einer für alle Sequenzen gleichen Zeitdauer mit einer von Sequenz zu Sequenz geänderten Größe eingeschaltet, so daß sich in y-Richtung eine bestimmte Phasenkodierung bzw. ein bestimmter Wert k_{y} ergibt. Das dadurch hervorgerufene MR-Signal wird im Zusammenwirken mit einem Lesegradienten (Gₓ, 3. Zeile) erfaßt (5. Zeile), falls die atmungsbedingte Verschiebung, die zuvor mit Hilfe des Navigatorimpulses β gemessen wurde, klein genug ist. Nach dem Auslesen wird der Phasenkodierungsgradient mit der gleichen Dauer und der gleichen Stärke wie zuvor - aber mit der entgegengesetzten Polarität - eingeschaltet, so daß die Phasenkodierung den stationären Zustand nicht beeinflußt.

Danach wird die Teilsequenz mit dem Hochfrequenzimpuls α noch L mal wiederholt, wobei L (z.B. 3 oder 4) so gewählt ist, daß sich nach diesen L Wiederholungen die Bewegungsphase nur unwesentlich geändert hat. Bei diesen Wiederholungen wird die Stärke des Phasenkodierungsgradienten G_{y} geändert. Nach den L Wiederholungen der Teilsequenz wird die gesamte Sequenz in Fig. 3 wiederholt, d.h. es wird erneut die Verschiebung gemessen, wonach wiederum vier Teilsequenzen auf den Untersuchungsbereich einwirken. Wenn die Bewegung des Patienten nicht mit Hilfe der Navigatorimpulse β erfaßt wird (z.B. mit Hilfe eines Atemgürtels), besteht die gesamte Sequenz nur aus den mit dem Hochfrequenzimpuls α eingeleiteten Teil und wird ständig wiederholt, bis genügend MR-Daten vorhanden sind.

Erfindungsgemäß wird der Schwellenwert der Verschiebung des Objektes gegenüber einer Referenzlage, bei dem bzw. unterhalb dessen das MR-Signal zur Rekonstruktion eines MR-Bild herangezogen wird, von der mit diesem MR-Signal verbundenen Phasenkodierung abhängig gemacht. Fig. 4 stellt die Abhängigkeit des Schwellenwertes vₛ als Funktion der Phasenkodierung k_{y} dar. Bei kleinen Werten von k_{y} ist der Schwellenwert sehr niedrig, weil die bei niedrigen Werten von k_{y} akquirierten MR-Signale einen höheren Informationsgehalt haben als die MR-Signale, die mit höheren Werten von k_{y} verbunden sind. Von dem Minimalwert von k_{y} = 0 steigt der Schwellenwert auf einen Maximalwert vₛₘₐₓ bei der größtmöglichen Phasenkodierung k_{ymax} an, und zwar vorzugsweise nach einer kubischen Funktion.

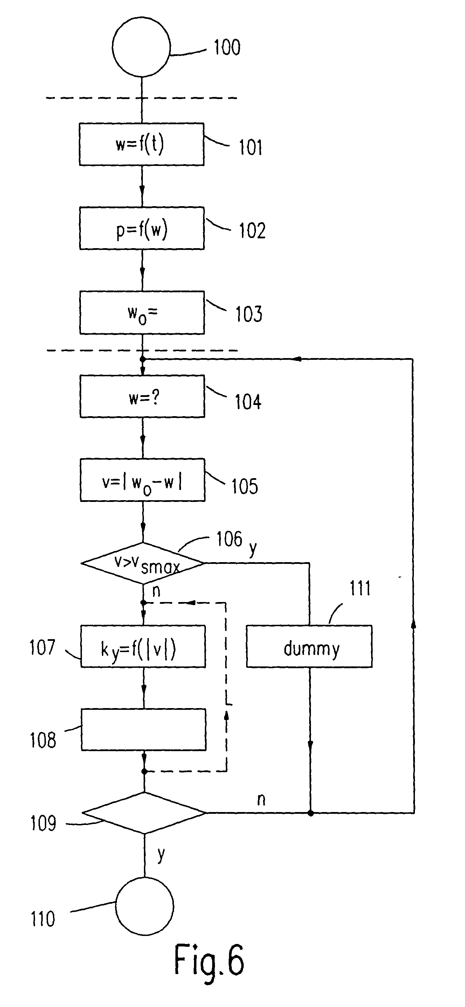

Fig. 5 erläutert die Auswirkungen dieser an die Bewegung angepaßten Erfassung der MR-Signale, wobei der gleiche Darstellungsmodus gewählt ist wie bei Fig. 1 und wobei ebenfalls davon ausgegangen wird, daß die MR-Signale mit einer zunehmenden Größe des Phasenkodiergradienten akquiriert werden. Wegen des niedrigen Schwellenwertes für kleine Werte von k_{y} dauert es bei dem erfindungsgemäßen Verfahren u.U. noch länger als bei dem in Fig. 1 dargestellten Verfahren, bis die MR-Signale erfaßt und gespeichert sind, die niedrigen Werten von k_{y} zugeordnet sind. Mit zunehmendem Wert von k_{y} steigt jedoch gemäß Fig. 4 der Schwellenwert für die Erfassung der MR-Signale und daher auch der Zeitraum innerhalb einer Atemperiode, innerhalb dessen die MR-Signale akquiriert und gespeichert werden können, so daß die mit höheren k_{y}-Werten verbundenen MR-Signale schneller erfaßt werden können als bei dem bekannten Verfahren. Deshalb ist die Gesamtzeit für die Akquisition der erforderlichen MR-Daten verringert - bei vergleichbarer Bildqualität.

Im folgenden wird anhand der Figuren 6 bis 8 eine bevorzugte Ausführungsform des erfindungsgemäßen Verfahrens erläutert. Fig. 6 stellt ein Flußdiagramm dar, das den Ablauf bei dieser bevorzugten Ausführungsform darstellt. Nach dem Start (Block 100) folgt zunächst eine Präparationsphase, in der die Atembewegung w ununterbrochen gemessen wird (Block 101), so daß sich deren zeitlicher Verlauf ergibt, wie in Fig. 1 und 5 - dort allerdings in Verbindung mit der Erfassung von MR-Signalen - angedeutet. Anhand des so gemessenen Bewegungsverlaufs wird festgestellt, mit welcher Wahrscheinlichkeit p die einzelnen Bewegungsphasen w während dieser Präparationszeit aufgetreten sind (Block 102).

Fig. 7 zeigt einen für eine Atembewegung typischen Verlauf mit zwei Wahrscheinlichkeitsmaxima, die sich bei eingeatmetem und ausgeatmetem Zustand ergeben. Im allgemeinen können sich nach einer Einatmung leicht differierende Werte ergeben (weshalb das zugehörige Maximum breiter und niedriger ist), während nach der Ausatmung meist der gleiche Wert w erreicht wird (weshalb das zugehörige Maximum schmaler, aber ausgeprägter ist als in der Einatmungsphase). Der diesem Maximum zugeordnete Wert wₒ wird im folgenden als Referenzlage benutzt (Block 103). Grundsätzlich könnte auch ein anderer Wert w gewählt werden. Dieser tritt jedoch mit einer geringeren Wahrscheinlichkeit während der Atembewegung auf, so daß sich die dafür erforderlichen Gesamtmeßzeiten verlängern würden.

Nach den Schritten 101 bis 103 ist die Präparationsphase abgeschlossen. Diese Präparationsphase läßt sich in der Regel so mit den übrigen Vorbereitungsprozeduren für die MR-Messung verschachteln, daß die gesamte Untersuchungszeit dadurch nicht nennenswert erhöht wird.

Nach der Festlegung der Referenzlage wₒ wird die momentane Lage w gemessen, z.B. mittels des in Fig. 3 dargestellten Navigatorimpulses β (Block 104). Danach wird aus dem Betrag der Differenz zwischen der Referenzlage wₒ und der aktuellen Lage w die Verschiebung v berechnet (Block 105). Es wird dann überprüft, ob der errechnete Wert v größer ist als der maximale Schwellenwert vₛₘₐₓ (Block 106). Ist dies nicht der Fall, dann wird in Block 107 eine bis dahin noch nicht erzeugte Phasenkodierung ermittelt, die bei dieser Verschiebung gemäß Fig. 4 noch zulässig ist, und diese Phasenkodierung wird bei der darauf folgenden Teilsequenz (rechte Hälfte von Fig. 3) vorgegeben. Das erzeugte MR-Signal wird erfaßt und gespeichert und steht zur Rekonstruktion eines MR-Bildes zur Verfügung. Die Verfahrensschritte 107 und 108 werden L mal wiederholt, d.h. z.B. drei oder viermal, wie gestrichelt angedeutet. Es erfolgt dann eine weitere Abfrage (Block 109), ob sämtliche Werte von k_{y} gemessen worden sind. Ist dies der Fall, dann ist die Akquisition der MR-Signale abgeschlossen (Block 110).

Wenn sich im Block 106 ergibt, daß die Verschiebung v größer ist als der maximale Schwellenwert vₛₘₐₓ, dann kann man die in der rechten Hälfte von Fig. 3 dargestellte Teilsequenz erzeugen (Block 111) - jedoch ohne das auftretende MR-Signal zu digitalisieren und zu speichern. Durch die Erzeugung einer solchen "dummy"-Sequenz wird der in Verbindung mit Fig. 3 erwähnte stationäre Zustand der Kernmagnetisierung aufrechterhalten. Wenn der Wert v jedoch wesentlich größer ist als vₛₘₐₓ, könnte das Erzeugen dieser dummy-Sequenz auch ganz unterbleiben, wobei die Erzeugung der dummy-Sequenzen erst dann wieder aufgenommen werden müßte, wenn der Wert v in die Nähe des maximalen Schwellenwertes νₛₘₐₓ kommt.

Wenn im Block 106 festgestellt wird, daß die Verschiebung unterhalb des maximalen Schwellenwertes ist und wenn festgestellt wird, daß für alle Werte k_{y}, die bei der betreffenden Verschiebung noch zulässig sind, bereits MR-Signale akquiriert wurden, gibt es zwei Möglichkeiten:
a) Es wird für einen k_{y}-Wert erneut ein MR-Signal erfaßt und gespeichert. Bei der nachfolgenden Rekonstruktion wird dann für diesen k_{y}-Wert gespeicherten MR-Signale dasjenige herangezogen, das mit einer geringeren Verschiebung v verknüpft ist. Dies setzt voraus, daß außer dem MR-Signal auch die zugehörige Verschiebung v gespeichert wird.
b) Es wird eine dummy-Sequenz erzeugt. Wenn im Block 109 festgestellt ist, daß noch nicht alle erforderlichen MR-Signale erfaßt sind, bzw. nachdem eine dummy-Sequenz erzeugt ist, wird die aus den Blöcken 104 ... 111 bestehende Schleife erneut durchlaufen, bis alle erforderlichen MR-Signale erfaßt und gespeichert sind.

Für den Fall, daß die Schritte 107 und 108 in einem MR-System nicht schnell genug vollzogen werden können, ist es auch möglich, aus der gemessenen Verschiebung und dem in der Präparationsphase ermittelten Bewegungsverlauf die Verschiebung v vorauszuberechnen, die nach einer bestimmten Verzögerung, z.B. 100 ms, erreicht ist. Die Schritte 106 ... 111 erfolgen dann in Abhängigkeit von der so vorausberechneten Verschiebung v nach der bestimmten Verzögerung.

Fig. 8 zeigt - in einer zu der Darstellung von Fig. 1 und Fig. 5 analogen Darstellung - die Möglichkeiten des anhand von Fig. 6 erläuterten MR-Verfahrens. Man erkennt, daß schon bei vergleichsweise großen Verschiebungen MR-Signale mit großem k_{y}-Wert erfaßt werden. Nur in einem vergleichsweise kleinen Zeitraum, in dem die Verschiebung besonders größ wird, werden keine MR-Signale weiterverarbeitet. Je geringer im weiteren Verlauf die Verschiebung v wird, desto niedriger wird der Wert k_{y}, bei dem MR-Signale erfaßt werden. In der nächsten Atemperiode ist die Pause, in der keine MR-Signale für die Weiterverarbeitung erfaßt werden, schon etwas größer, weil die meisten MR-Signale für hohe k_{y}-Werte bereits in der vorangehenden Sequenz erfaßt wurden. Gegebenenfalls können diese Sequenzen aber auch wiederholt werden, wie in Verbindung mit Fig. 6 erläutert. Nach vergleichsweise wenigen Atemperioden ist dann ein vollständiger Datensatz erfaßt.

Die Erfindung wurde vorstehend der einfacheren Darstellbarkeit halber in Verbindung mit einem MR-Verfahren erläutert, das der Erzeugung eines MR-Bildes von einem zweidimensionalen Bereich dient - der durch den Hochfrequenzimpuls α angeregten Schicht (Fig. 3). Die Patienten können in den meisten Fällen den Atem für einige Sekunden anhalten - genug, um bei einem zweidimensionalen MR-Verfahren mit einer Repititionszeit von z.B. 15 ms 128 oder auch 256 MR-Signale mit verschiedener Phasenkodierung zu akquirieren. Bei dreidimensionalen Verfahren ist es nicht möglich, den Atem solange anzuhalten, und deshalb zeigt die Erfindung bei diesen Verfahren besondere Vorteile. Als dreidimensionales Verfahren eignet sich z.B. das sogenannte 3DFT-Verfahren, bei dem die Phase außer in der y-Richtung noch in einer weiteren Richtung kodiert wird. Die Erfindung ist aber auch bei solchen dreidimensionalen Verfahren anwendbar, bei der die in Verbindung mit Fig. 3 erläuterte Phasenkodierung nur in einer Richtung erfolgt, während die MR-Information für die dazu senkrechte Ebene mit Hilfe eines anderen Verfahrens erfolgen kann, z.B. Turbospinecho (TSE), GRASE oder segmentiertem EPI. Bei diesen Verfahren wird nach jeder Anregung gleichmäßig über den k-Raum verteilte Information gewonnen, so daß es nicht sinnvoll ist, jeder Anregung einen unterschiedlichen Schwellenwert der Bewegung zuzuordnen. Wenn jedoch in der dazu senkrechten Richtung die Phasenkodierung in der erläuterten Weise erfolgen kann, ist die Anwendung des erfindungsgemäßen Verfahrens ohne weiteres möglich.

## Patentansprüche

1. MR-Verfahren mit reduzierten Bewegungsartefakten, bei dem fortlaufend die Verschiebung eines in einem Untersuchungsbereich befindlichen pulsierenden Objektes oder eines Teils davon aus einer Referenzlage (w₀) gemessen wird, und bei dem nur diejenigen im Untersuchungsbereich erzeugten MR-Signale für die Rekonstruktion eines MR-Bildes herangezogen werden, bei deren Erfassung die Verschiebung (v) aus der Referenzlage einen Schwellenwert (vₛ) erreicht bzw. unterschreitet, der von dem zeitlichen Integral (k_{y}) des vor der Erfassung eines MR-Signals jeweils auf den Untersuchungsbereich einwirkenden Phasenkodierungsgradienten (G_{y}) abhängt,
**dadurch gekennzeichnet, daß** in Abhängigkeit von der jeweils gemessenen Verschiebung (v) das zeitliche Integral (k_{y}) des jeweils nächsten Phasenkodierungsgradienten (G_{y}) vorgegeben wird.

2. MR-Verfahren nach Anspruch 1,
**dadurch gekennzeichnet, daß** der Schwellenwert (vₛ) mit zunehmendem Integral des Phasenkodierungsgradienten (k_{y}) vorzugsweise nach einer kubischen Funktion steigt.

3. MR-Verfahren nach einem der vorhergehenden Ansprüche,
**dadurch gekennzeichnet, daß** die Bewegung des Objektes mittels einer MR-Sequenz gemessen wird, die die Kernmagnetisierung längs einer Linie anregt.

4. MR-Verfahren nach Anspruch 1,
**dadurch gekennzeichnet, daß** in einer Präparationsphase nur die pulsierende Bewegung des Objektes bzw, eines Teils davon gemessen wird und daß automatisch diejenige Lage (wₒ) als Referenzlage, bestimmt wird, in der sich das Objekt jeweils am längsten befindet.

5. MR-Anordnung zur Durchführung des Verfahrens nach Anspruch 1 mit
- einem Magneten (1) zur Erzeugung eines homogenen stationären Magnetfeldes,
- einer Gradientenspulenanordnung (2) zur Erzeugung eines magnetischen Gradientenfeldes,
- wenigstens einer Hochfrequenzspulenanordnung (10, 20) zur Erzeugung von Hochfrequenzimpulsen bzw. zum Empfangen von MR-Signalen,
- Mitteln (24) zum Erzeugen von MR-Bildern aus den MR-Signalen,
- Mitteln (10,23,24) zur fortlaufenden Messung der Verschiebung (v) eines in einem Untersuchungsbereich befindlichen pulsierenden Objektes oder eines Teils davon aus einer Referenzlage (wₒ)
- einer programmierbaren Steuereinheit (5) zum Steuern der vorgenannten Mittel und der Spulenanordnungen, die so programmiert ist, daß nur diejenigen im Untersuchungsbereich erzeugten MR-Signale für die Rekonstruktion eines MR-Bildes herangezogen werden, bei deren Erfassung die Verschiebung (v) aus der Referenzlage (w₀) einen Schwellenwert (vₛ) erreicht bzw. unterschreitet, der von dem zeitlichen Integral (k_{y}) des vor der Erfassung eines MR-Signals jeweils auf den Untersuchungsbereich einwirkenden Phasenkodierungsgradienten (G_{y}) abhängt,
**dadurch gekennzeichnet, daß** die Steuereinheit (5) in Abhängigkeit von der jeweils gemessenen Verschiebung (v) das zeitliche Integral (k_{y}) des jeweils nächsten Phasenkodierungsgradienten (G_{y}) vorgibt.

## Claims

1. An MR method with reduced motion artefacts in which the displacement of a pulsating object, or a part thereof, present in an examination zone is continuously measured with respect to a reference position (wₒ), and in which the reconstruction of an MR image utilizes exclusively the MR signals acquired from the examination zone while the displacement (v) from the reference position reaches or drops below a threshold value (vₛ) which is dependent on the time integral (k_{y}) of the respective phase encoding gradient (G_{y}) acting on the examination zone prior to the acquisition of an MR signal,
**characterized in that** the time integral (k_{y}) of the respective next phase encoding gradient (G_{y}) is preset in dependence on the relevant measured displacement (v).

2. An MR method as claimed in claim 1,
**characterized in that** as the integral of the phase encoding gradient (k_{y}) increases the threshold value (vₛ) increases preferably as a cubic function.

3. An MR method as claimed in one of the preceding claims,
**characterized in that** the movement of the object is measured by means of an MR sequence which excites the nuclear magnetization along a line.

4. An MR method as claimed in claim 1,
**characterized in that** during a preparation phase only the pulsating movement of the object, or of a part thereof, is measured and that the position (wₒ) in which the object is present for the longest period of time is automatically determined to be the reference position.

5. An MR device for carrying out the method of Claim 1, including
- a magnet (1) for generating a uniform, steady magnetic field,
- a gradient coil system (2) for generating a magnetic gradient field,
- at least one RF coil system (10, 20) for generating RF pulses and for receiving MR signals,
- means (24) for forming MR images from the MR signals,
- means (10, 23, 24) for continuously measuring the displacement (v) of a pulsating object, or of a part thereof, present in an examination zone, relative to a reference position (wₒ),
- a programmable control unit (5) for controlling said means and coil systems which is programmed in such a manner that the reconstruction of an MR image utilizes exclusively the MR signals acquired from the examination zone while the displacement (v) from the reference position (wₒ) reaches or drops below a threshold value (vₛ) which is dependent on the time integral (k_{y}) of the respective phase encoding gradient (G_{y}) acting on the examination zone prior to the acquisition of an MR signal,
**characterized in that** the control unit (5) presets the time integral (k_{y}) of the respective next phase encoding gradient (G_{y}) in dependence on the relevant measured displacement (v).

## Revendications

1. Procédé RM à artefacts de mouvement réduits, dans lequel la translation d'un objet pulsant ou d'une partie de celui-ci se trouvant dans un champ d'examen est mesurée en permanence à partir d'une position de référence (Wₒ), et dans lequel sont utilisés pour la reconstitution d'une image RM seuls les signaux RM produits dans le champ d'examen et pour la saisie desquels la translation (v) à partir de la position de référence atteint ou est inférieure à une valeur seuil (vₛ) dépendant de l'intégrale temps (k_{y}) d'un gradient de codage de phase (G_{y}) agissant respectivement sur le champ d'examen avant la saisie d'un signal RM,
**caractérisé en ce que** l'intégrale temps (k_{y}) du gradient de codage de phase suivant (G_{y}) est prédéterminé en fonction de la translation respectivement mesurée (v).

2. Procédé RM suivant la revendication 1,
**caractérisé en ce que** la valeur seuil (vₛ) à intégrale croissante du gradient de codage de phase (k_{y}) augmente de préférence vers une fonction cubique.

3. Procédé RM suivant l'une des revendications précédentes,
**caractérisé en ce que** le mouvement de l'objet est mesuré au moyen d'une séquence RM qui stimule la magnétisation nucléaire de manière linéaire.

4. Procédé RM suivant la revendication 1,
**caractérisé en ce que** dans une phase préparatoire, seul le mouvement pulsant de l'objet ou d'une partie de celui-ci est mesuré et que la position (wₒ) dans laquelle l'objet se trouve respectivement le plus longtemps est déterminée automatiquement.

5. Structure RM pour l'exécution de procédé suivant la revendication 1 avec
- un aimant (1) pour création d'un champ magnétique stationnaire homogène,
- un arrangement de bobines à gradients (2) pour production d'un champ magnétique de gradients,
- au moins un arrangement de bobines haute fréquence (10,20) pour la production d'impulsions haute fréquence ou la réception de signaux RM,
- des moyens (24) pour la création d'images RM à partir des signaux RM,
- des moyens (10,23,24) pour la mesure constante de la translation (v) d'un objet pulsant ou d'une partie de celui-ci se trouvant dans un champ d'examen à partir d'une position de référence (wₒ)
- un organe de commande programmé (5) pour la commande des moyens ci-dessus et des arrangements de bobines, programmé de telle manière que sont utilisés pour la reconstitution d'une image RM seuls les signaux produits dans le champ d'examen pour la saisie desquels la translation (v) à partir de la position de référence (wₒ) atteint ou est inférieure à une valeur seuil (vₛ) qui est en fonction de l'intégrale temps (k_{y}) du gradient de codage de phase (G_{y}) agissant sur le champ d'examen avant la saisie d'un signal RM,
**caractérisée en ce que** l'organe de commande (5) fixe à l'avance l'intégrale temps (k_{y}) du gradient de codage de phase (G_{y}) correspondant suivant en fonction de la translation respectivement mesurée (v).
